(19) Europäisches Patentamt / European Patent Office / Office européen des brevets

(11) **EP 4 305 432 B1**

(12) **FASCICULE DE BREVET EUROPEEN**

(45) Date de publication et mention
de la délivrance du brevet:
**07.05.2025   Bulletin 2025/19**

(21) Numéro de dépôt: **22817706.9**

(22) Date de dépôt: **15.11.2022**

(51) Classification Internationale des Brevets (IPC):
**G01R 31/26** *(2020.01)*        **G01R 31/28** *(2006.01)*

(52) Classification Coopérative des Brevets (CPC):
**G01R 31/2619; G01R 31/2628; G01R 31/2632;
G01R 31/2642; G01R 31/2817**

(86) Numéro de dépôt international:
**PCT/EP2022/081876**

(87) Numéro de publication internationale:
**WO 2023/094205 (01.06.2023 Gazette 2023/22)**

(54) **PROCEDE ET DISPOSITIF DE MESURE DE L'ETAT DE SANTE DE COMPOSANTS ELECTRONIQUES A SEMI-CONDUCTEURS**

VERFAHREN UND VORRICHTUNG ZUR MESSUNG DES GESUNDHEITSZUSTANDES VON HALBLEITERBASIERTEN ELEKTRONISCHEN BAUTEILEN

METHOD AND DEVICE FOR MEASURING THE STATE OF HEALTH OF SEMICONDUCTOR-BASED ELECTRONIC COMPONENTS

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité:   **23.11.2021   FR 2112413**

(43) Date de publication de la demande:
**17.01.2024   Bulletin 2024/03**

(73) Titulaire: **Université Gustave Eiffel
77420 Champs-Sur-Marne (FR)**

(72) Inventeurs:
• **KHATIR, Zoubir
92350 Le Plessis-Robinson (FR)**
• **LALLEMAND, Richard
75012 PARIS (FR)**
• **IBRAHIM, Ali
78330 Fontenay Le Fleury (FR)**

(74) Mandataire: **Fidal Innovation
4-6 avenue d'Alsace
92400 Courbevoie (FR)**

(56) Documents cités:
**EP-A2- 3 896 414**

• **ARYA ABHINAV ET AL: "Accurate Online Junction Temperature Estimation of IGBT Using Inflection Point Based Updated I-V Characteristics", IEEE TRANSACTIONS ON POWER ELECTRONICS, INSTITUTE OF ELECTRICAL AND ELECTRONICS ENGINEERS, USA, vol. 36, no. 9, 17 March 2021 (2021-03-17), pages 9826 - 9836, XP011858202, ISSN: 0885-8993, [retrieved on 20210603], DOI: 10.1109/ TPEL.2021.3066287**

**Description**

**DOMAINE DE L'INVENTION**

La présente invention se rapporte à un procédé et un dispositif de mesure de l'état de santé de composants électroniques.

Plus précisément, l'invention se rapporte à un procédé de suivi de la dégradation par fatigue thermique de composants électroniques de puissance à semi-conducteurs pouvant être bipolaires, tels que les diodes de puissance, ou mixtes tels que les composants IGBT (transistor bipolaire à grille isolée, « Insulated Gate Bipolar Transistor »).

**ARRIÈRE-PLAN TECHNOLOGIQUE**

Les composants électroniques utilisés dans le domaine de l'électronique de puissance permettent de gérer l'énergie électrique ou de réaliser une conversion d'énergie électrique. Les utilisations de ces composants sont très variées. On les retrouve notamment dans les véhicules électriques (voiture électrique, bus, train, métro, ...) ou dans le domaine de la production d'énergie renouvelable, par exemple dans les éoliennes ou les panneaux photovoltaïques, mais aussi les réseaux de transport et embarqués (« Flexible Alternating Current Transmission System » **(FACTS ou encore système de transmission flexible en courant alternatif),** Smart Grids.), la variation de vitesse, ainsi que des applications pour un public plus large (électroménager, informatique...).

Ils sont utilisés dans de très larges gammes de puissance et sont le plus souvent soumis à un cyclage en température d'amplitude éventuellement importante.

La fatigue thermique liée à leurs conditions d'utilisation est le principal facteur de vieillissement des composants de puissance.

Ce phénomène de vieillissement thermique peut être compris à l'aide de l'exemple qui suit.

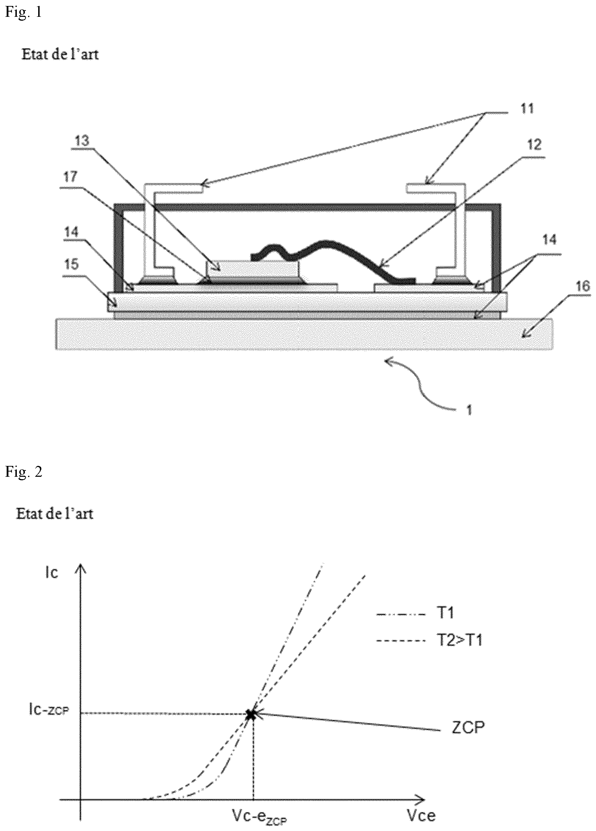

Un module IGBT, qui fait partie de la catégorie des composants électroniques à semi-conducteurs mixtes, est représenté sur la figure 1. On peut observer sur cette figure que la puce est connectée aux bornes de connexion vers l'extérieur du module par l'intermédiaire d'un fil de liaison (ou fil de « bonding ») en métal, par exemple en aluminium.

Lors du fonctionnement du module, la température des différents éléments qui le constituent a tendance à varier, cycliquement ou non, avec une amplitude qui peut atteindre plusieurs dizaines de degrés.

Les coefficients de dilatation thermique de ces éléments étant différents, les variations de température provoquent des déformations différentes de ces éléments. Ceci peut alors induire des fissures dans l'un ou l'autre de ces éléments, notamment le fil de « bonding », voire une rupture de l'association entre deux de ces éléments, par exemple au niveau de l'interface puce - fil de « bonding ».

Ces différents phénomènes se traduisent dans un premier temps par une dégradation des performances du composant, notamment en termes de rendement énergétique, et dans un second temps par une défaillance du composant.

Le module IGBT comporte un support diffuseur de chaleur, qui permet d'évacuer la chaleur produite en cours de fonctionnement dans les différentes parties du module et notamment au niveau de la puce et limiter les variations de température au sein du module. Toutefois, cela ne suffit pas à empêcher ces variations de température et donc le vieillissement thermomécanique du module.

Les phénomènes de vieillissement sont ici décrits à titre d'exemple pour un module IGBT mais on observe des phénomènes analogues pour tous les composants à semi-conducteurs de puissance.

Pour tous les domaines d'utilisation cités plus haut (systèmes de transport à traction électrique, variation de vitesse ou conversion d'énergie), le suivi de l'état de vieillissement de ces composants est un enjeu majeur puisqu'il permet d'optimiser les opérations de maintenance. Des opérations de diagnostic préalables à ces opérations de maintenance peuvent être effectuées sur un site dédié et équipé, ce qui nécessite de déplacer le dispositif vers ce site en interrompant son utilisation. Il est aussi possible de réaliser les diagnostics in situ, pendant l'utilisation du composant. Ainsi, les diagnostics peuvent être effectués pendant le roulage d'un véhicule ou entre deux périodes de roulage successives sans pour autant déplacer le véhicule.

Dans les cas où il n'est pas souhaitable ou possible de déplacer le dispositif que le composant électronique de puissance équipe, il est connu de mettre en œuvre des méthodes de mesure et de contrôle de la température.

Ainsi, la demande de brevet européenne EP2564163A2 divulgue un capteur optique permettant le contrôle de la température dans un module semi-conducteur, tel qu'un module IGBT, de manière à en prévenir les défaillances.

Cette méthode permet de limiter les variations de température au niveau des composants mais ne fournit pas un indicateur du vieillissement de ce composant.

De manière plus commune, et notamment en vue d'établir des diagnostics in situ, différents indicateurs du vieillissement des composants électroniques ont été proposés, parmi lesquels une tension émetteur-collecteur à l'état passant (notée $Vce_{ON}$ pour un composant IGBT) ou une durée de commutation. De tels indicateurs sont notamment décrits dans l'article "Physics-of-Failure, Condition Monitoring, and Prognostics of Insulated Gate Bipolar Transistor Modules: A Review", H. Oh, B. Han, P. McCluskey, C. Han and B. D. Youn, IEEE Transactions on Power Electronics, vol. 30, no. 5, pp. 2413-2426, May 2015, ou encore dans l'article "Accurate Online Junction Temperature Estimation of IGBT Using Inflection Point Based Updated I-V Characteristics", A. Arya, A. Chanekar, P. Deshmukh, A. Verma and S. Anand, IEEE Transactions on Power Electronics, vol. 36, no. 9, pp. 9826-9836, Sept. 2021.

La plupart de ces indicateurs nécessitent la mesure complémentaire de la température du composant de puissance. Ainsi, la mesure de $Vce_{ON}$ doit, pour être pertinente, être effectuée à température de jonction maîtrisée et pour une valeur de courant fixée.

La mesure de température est effectuée, de manière directe ou indirecte, avec des capteurs dont la mise en œuvre et l'étalonnage sont complexes lorsque la précision du capteur est élevée, comme le montre la table 1 p.9827 de l'article "Accurate Online Junction Temperature Estimation of IGBT Using Inflection Point Based Updated I-V Characteristics". Pour surmonter ces limitations, d'autres indicateurs de l'état de santé des composants électroniques, indépendants de la température - ou tout au moins ne nécessitant pas de mesure de température - sont donc recherchés.

L'article "On-line Health Monitoring of Wire-Bonded IGBT Power Modules using On-State Voltage at Zero-Temperature-Coefficient", N. Degrenne and S. Mollov, PCIM Europe 2018 ; International Exhibition and Conference for Power Electronics, Intelligent Motion, Renewable Energy and Energy management, 2018, pp. 1-7, divulgue une méthode de suivi de la dégradation d'un module IGBT basée sur le point ZCP de ce module (ce point étant noté ZTC dans cet article). L'hypothèse sur laquelle se fonde la méthode de suivi de cet article est que le point ZTC n'évolue pas avec la dégradation du module IGBT dans le plan courant-tension. Tous les composants de puissance bipolaires ou mixtes présentent à l'état passant un coefficient de température négatif à faible niveau de courant, c'est-à-dire qu'une augmentation de la température à intensité de courant électrique de collecteur Ic constante se traduit par une augmentation de la tension collecteur-émetteur, notée Vce, tandis qu'à fort niveau de courant, ils présentent un coefficient de température positif. Entre ces deux comportements existe un point ZCP (« Zero Coefficient Point »), c'est-à-dire un point de la caractéristique statique courant-tension (Ic, Vce) du composant (pris dans un état de santé donné) pour lequel la tension émetteur-collecteur V,ZCP correspondant à l'intensité du courant de collecteur I,ZCP est indépendante de la température à laquelle cette caractéristique tension-courant a été tracée. On peut visualiser ce point sur la figure 2 de la présente demande et sur la figure 10 de l'article "On-line Health Monitoring of Wire-Bonded IGBT Power Modules using On-State Voltage at Zero-Temperature-Coefficient" .

Le point ZCP évolue en fonction de l'usure du composant électronique de puissance, mais cette évolution n'était pas documentée précisément jusqu'à ce jour, de sorte que l'exploitation de ce point reposait sur des hypothèses non démontrées ou erronées.

Ainsi, les auteurs du document "On-line Health Monitoring of Wire-Bonded IGBT Power Modules using On-State Voltage at Zero-Temperature-Coefficient" font l'hypothèse a priori que l'intensité du courant de collecteur I,ZCP est indépendante de l'état de santé du composant alors que la tension V,ZCP augmente au fur-et-à-mesure de son vieillissement. Ils proposent sur la base de cette hypothèse de réaliser de manière répétée des mesures de la tension V,ZCP à I,ZCP fixée à une valeur déterminée par un étalonnage initial du composant, au début de son utilisation.

Toutefois, cette hypothèse semble incorrecte à la lumière de la publication "Accurate Online Junction Temperature Estimation of IGBT Using Inflection Point Based Updated I-V Characteristics", A. Arya, A. Chanekar, P. Deshmukh, A. Verma and S. Anand, IEEE Transactions on Power Electronics, vol. 36, no. 9, pp. 9826-9836, Sept. 2021. Cette publication propose un capteur de température pour un composant électronique par mesure indirecte de bonne précision.

Ce document suggère par la même occasion la possibilité d'un suivi de l'état de santé d'un tel composant au moyen d'une mesure de résistance. Cette proposition est elle aussi basée sur l'hypothèse que l'intensité du courant de collecteur I,ZCP (notée dans cet article Ic,inf) est indépendante de l'état de santé du composant. Cette hypothèse est notamment rappelée au paragraphe III.A.2) : « the value of Ic,inf is assumed to be same for HIVC [healthy characteristic] and DIVC [degraded characteristic] ».

Cependant, les mesures présentées sur les figures 14 a et 14 b vont à l'encontre de cette hypothèse. On peut observer sur cette figure le point de coefficient de température nul, et en particulier que l'intensité du courant en ce point dépend de l'état d'usure du composant. Il est donc probable que les indicateurs proposés dans les deux articles précédemment décrits ne sont pas d'une précision satisfaisante.

L'invention vise ainsi à proposer un procédé de suivi en temps réel de la dégradation de l'état d'un composant électronique de puissance à semi-conducteurs pouvant être bipolaire ou mixte, ce procédé étant peu coûteux, facile à mettre en œuvre, et exploitable dans une optique de maintenance prédictive.

## RÉSUMÉ DE L'INVENTION

Ainsi l'invention est définie par un procédé de mesure de l'état de santé selon la revendication 1.

Grâce à ces dispositions, le suivi de l'état de santé du composant électronique est simplifié et effectué avec une meilleure sensibilité que celle obtenue avec l'indicateur traditionnel basé sur le "$Vce_{ON}$". Notamment, il ne nécessite qu'un capteur de tension électrique et un capteur d'intensité de courant électrique. Il n'est pas nécessaire de mettre en œuvre un capteur de température.

Selon différents aspects, il est possible de prévoir l'une et/ou l'autre des caractéristiques ci-dessous prises seules ou en combinaison.

Selon une réalisation, aucun capteur de température n'est mis en œuvre ni aucune estimation de température n'est nécessaire pour les étapes a, b et c du procédé, l'indicateur quantitatif D(ti) de la dégradation du composant électronique étant indépendant de la température.

L'information sur la température n'est en effet pas nécessaire dans la mesure où le point de coefficient de température nul est par définition indépendant de la température à laquelle le composant fonctionne à laquelle la ou les caractéristiques courant-tension (I,V) sont établies. Il n'est en conséquence pas non plus nécessaire de maintenir la température du composant électronique à une valeur adaptée à la mesure comme dans certains procédés de l'art antérieur. Ainsi, le procédé ne nécessite pas de mesure de température, ce qui entraîne une diminution des coûts de mise en œuvre.

Selon une réalisation, le procédé de mesure comprend avant l'étape a :

i - une étape comprenant au moins deux séries de mesures de l'intensité de courant électrique I par le capteur d'intensité de courant électrique et de la tension électrique V par le capteur de tension électrique, les séries de mesures (I, V) étant prises à des températures différentes ii - une étape de calcul par le processeur, d'une valeur de tension électrique V,ZCP0 et d'une valeur de courant électrique I,ZCP0 au point de coefficient de température nul ZCP, à partir des mesures de l'étape i, le point de coefficient de température nul ZCP étant le point de croisement des deux séries de mesures (I, V) de l'étape i, l'intensité I(t0) et la tension V(t0) à l'instant initial étant égales respectivement à I,ZCP0 et V,ZCP0.

Grâce à cette disposition, le point de coefficient de température nul peut être déterminé avec une bonne précision, ce qui permet d'améliorer la précision du procédé de suivi de l'état de santé du composant électronique

Selon une réalisation du procédé de mesure, l'au moins un composant électronique de puissance à semi-conducteurs, est embarqué ou installé dans un système électrique en fonctionnement, le procédé de mesure de l'état de santé du composant étant réalisé en exploitation du système électrique.

Ainsi, le suivi de santé n'est pas limité à une étude ex situ du composant électronique et le suivi de santé est adapté pour toutes les utilisations du composant électronique.

Selon une réalisation, la mesure de la tension électrique V(ti) est effectuée à l'étape b avec une précision relative qui dépend du type du composant électronique de puissance, cette précision relative ayant une valeur inférieure à 5%.

Il a en effet été observé qu'un indicateur de l'état de santé du composant électronique suivant l'invention, basé sur le point de coefficient de température nul, fournit une indication de précision suffisante dès lors que la tension V(t0) mesurée à l'étape b diffère de moins de 5% de la tension V,ZCP0 mesurée à l'étape a.

Selon une réalisation possible, le procédé de mesure de l'état de santé du composant, notamment pour déterminer l'évolution de son vieillissement et de sa dégradation, est mis en œuvre de manière itérative au cours du temps par différentes mesures d'intensité I(ti) à différents instants ti, ces intensités I(ti) étant mesurées lorsque la tension V à ces différents instants ti est égale à la tension V,ZCP0, et étant comparées à l'intensité I(t0)=I,ZCP0 à l'instant initial t0.

Ainsi, le procédé du suivi de santé comprend des mesures successives permettant de déterminer l'indicateur quantitatif de dégradation D(ti) à des instants ti successifs. Il permet donc de suivre l'évolution de l'état de santé du composant électronique.

Selon une réalisation, la dégradation concerne la dégradation des interconnexions électriques des composants.

Ainsi, le suivi de santé reflète l'état des interconnexions électriques. Il est donc localisé permettant de réparer l'interconnexion dégradée ou de remplacer le composant concerné.

L'invention est aussi définie par un dispositif de mesure de l'état de santé selon la revendication 11.

Grâce à ces dispositions, le dispositif peut être disposé à l'intérieur d'un système pour suivre l'état de santé en continu d'un ou de plusieurs composants et il ne comprend pas nécessairement de capteur de température.

Selon une réalisation du dispositif de mesure, l'au moins un composant électronique de puissance à semi-conducteurs est bipolaire ou mixte.

Ainsi, le dispositif de mesure permet d'étudier l'état de santé de composants électroniques complexes.

L'invention se rapporte également à un module électronique de puissance intégrant un dispositif de mesure pour au moins deux composants électroniques en parallèle et/ou série.

Ainsi, le dispositif de mesure peut être disposé dans un système et permet le suivi de santé d'un composant électronique constitué de plusieurs composants placés en parallèle ou en série, en même temps ou séparément.

L'invention se rapporte en outre à un système embarquant : un ou plusieurs modules électroniques de puissance, le dispositif de mesure d'au moins un composant électronique de puissance intégré dans chaque module fournissant un indicateur de dégradation.

Ainsi, ces systèmes sont autonomes et permettent de suivre l'état de santé de chacun de leurs composants ou de leurs groupes de composants sans devoir utiliser un moyen externe.

L'invention se rapporte en outre à un système embarquant : un ou plusieurs modules électroniques de puissance, le dispositif de mesure d'au moins un composant électronique de puissance intégré dans chaque module fournissant au moins un indicateur de dégradation d'au moins un composant électronique de puissance de ce module.

L'invention se rapporte encore à un système embarquant un ou plusieurs modules électroniques de puissance suivant les modes de réalisation précédents, le système étant un système de gestion de l'énergie électrique et/ou de conversion d'énergie électrique pour les énergies renouvelables ou un système de transports à traction électrique ou un système stationnaire.

L'invention est aussi définie par un programme de calcul comprenant des instructions de code de programme pour l'exécution des étapes du procédé de mesure de l'état de santé d'un composant électronique de puissance à semi-conducteurs selon l'un des modes réalisations précédents lorsque le programme est exécuté par le dispositif de l'invention.

Ainsi, le suivi de l'état de santé peut être éventuellement automatisé et ne nécessite pas l'intervention d'une personne.

Selon une réalisation du programme de calcul, le procédé de mesure de l'état de santé est appliqué au système embarquant un ou plusieurs modules électroniques de puissance selon l'un des modes de réalisation précédent, et si le procédé de mesure renvoie un indicateur quantitatif de dégradation supérieur à une valeur seuil prédéterminée, le programme de calcul applique le procédé de mesure à chaque composant électronique de puissance à semi-conducteurs du système embarquant un ou plusieurs modules électroniques de puissance

Ainsi, le procédé de mesure permet de vérifier l'état de santé global, avant d'appliquer le procédé de mesure à chaque composant pour pouvoir identifier le composant subissant une dégradation, la première mesure permet d'économiser du temps de calcul lorsque l'état de santé global ne présente pas de dégradation.

Le franchissement d'un seuil, préalablement fixé sur l'indicateur quantitatif D(ti) de la dégradation d'un composant électronique, peut notamment être détecté automatiquement et générer une alerte pour l'utilisateur.

La description concerne aussi un procédé de mesure de l'état de santé à une date t d'un composant électronique à semi-conducteurs comportant au moins une borne d'entrée et une borne de sortie et présentant un point de coefficient de température nul à la date t, le procédé comprenant :

a1- on mesure une intensité 1,ZCP(t) d'un courant électrique traversant la borne d'entrée à la date t au point de coefficient de température nul du composant électronique en régime permanent au moyen d'un capteur d'intensité de courant électrique, une tension électrique V entre la borne d'entrée et la borne de sortie étant égale à une tension entre ces bornes au point de coefficient de température nul V,ZCP.

b1- on calcule au moyen d'un premier processeur configuré pour recevoir des informations du capteur d'intensité de courant électrique un indicateur quantitatif de l'état de santé du composant électronique à partir de l'intensité du courant électrique traversant la borne d'entrée 1,ZCP(t) mesurée.

Dans un mode de réalisation du procédé de mesure de l'état de santé à une date t d'un composant électronique à semi-conducteurs, aucun capteur de température n'est mis en œuvre pour les étapes a1 et b1.

Dans un mode de réalisation, le procédé de mesure de l'état de santé à une date t d'un composant électronique à semi-conducteurs comprend avant l'étape a :

i1 - on fixe successivement la température du composant électronique pris dans un état initial à au moins deux températures différentes au moyen d'un dispositif de contrôle de la température et on mesure à chacune des au moins deux températures au moyen d'un capteur de tension électrique au moins deux tensions électriques V entre les bornes d'entrée et de sortie pour deux intensités de courant électrique traversant la borne d'entrée différentes, lesdites intensités de courant électrique étant mesurées au moyen d'un capteur d'intensité de courant électrique ;

ii1 - on calcule, au moyen d'un processeur configuré pour recevoir des informations desdits capteurs de tension électrique et d'intensité de courant électrique une valeur de la tension électrique V,ZCP au point de coefficient de température nul à partir desdites intensités de courant électrique et tensions électriques mesurées.

Dans un mode de réalisation du procédé de mesure de l'état de santé à une date t d'un composant électronique à semi-conducteurs, on calcule en outre au moyen dudit second processeur une valeur de l'intensité I,ZCP,in du courant électrique traversant la borne d'entrée au point de coefficient de température nul du composant électronique pris dans l'état initial à partir desdites intensités de courant électrique et tensions électriques mesurées à l'étape i1. Selon un mode de réalisation du procédé de mesure de l'état de santé à une date t d'un composant électronique à semi-conducteurs, l'indicateur quantitatif de l'état de santé du composant est une fonction de l'intensité du courant électrique traversant la borne d'entrée 1,ZCP(t) à la date t.

Selon un mode de réalisation du procédé de mesure de l'état de santé à une date t d'un composant électronique à semi-conducteurs, on fournit de plus une valeur de l'intensité 1,ZCP,in du courant électrique traversant la borne d'entrée au point de coefficient de température nul du composant électronique pris dans un état initial et dans lequel l'indicateur quantitatif de l'état de santé du composant est une fonction seulement de l'intensité du courant électrique traversant la borne d'entrée I,ZCP(t) à la date t et de l'intensité du courant électrique traversant la borne d'entrée à l'état initial I,ZCP,in.

Selon un mode de réalisation du procédé de mesure de l'état de santé à une date t d'un composant électronique à semi-conducteurs , la tension électrique entre les bornes d'entrée et de sortie au point de coefficient de température nul V,ZCP est fixée à une précision relative dont la valeur est inférieure à 5%.

Selon un mode de réalisation du procédé de mesure de l'état de santé à une date t d'un composant électronique à semi-conducteurs, on met en œuvre de manière itérative au cours du temps le procédé de mesure.

La description porte encore sur un dispositif de mesure de l'état de santé à une date t d'un composant électronique à semi-conducteurs comportant au moins une borne d'entrée et une borne de sortie et présentant un point de coefficient de température nul, le dispositif comprenant un capteur d'intensité de courant électrique et un au moins un processeur configurés pour la mise en œuvre des étapes suivantes :

a1 - on mesure une intensité d'un courant électrique traversant la borne d'entrée I,ZCP(t) à la date t au point de coefficient de température nul du composant électronique en régime permanent au moyen du capteur d'intensité de courant électrique, une tension électrique entre les bornes d'entrée et de sortie étant égale à une tension entre les bornes d'entrée et de sortie au point de coefficient de température nul V,ZCP.

b1- on calcule au moyen du processeur un indicateur quantitatif de l'état de santé du composant électronique à partir de l'intensité du courant électrique traversant la borne d'entrée I,ZCP(t) mesurée.

## BRÈVE DESCRIPTION DES DESSINS

Des modes de réalisation de l'invention seront décrits ci-dessous par référence aux dessins, décrits brièvement ci-dessous :

Fig. 1 représente un module IGBT selon l'état de la technique.

Fig. 2 représente les caractéristiques statiques (Ic, Vce) schématiques d'un module IGBT, à deux températures T1 et T2, telles que T1<T2 selon l'état de la technique.

Fig. 3 représente dans le plan (Vce, Ic) la position du point ZCP d'un module IGBT en fonction de la dégradation de ce module, obtenue à partir d'une simulation de ce module.

Fig. 4 représente dans le plan (Vce, Ic) la position du point ZCP d'un module IGBT en fonction de la dégradation de ce module, obtenue en conditions réelles, ainsi que les positions de ce point obtenues à partir d'une simulation de ce module.

Fig. 5a représente, pour un module IGBT, la variation relative d'un indicateur de vieillissement selon l'état de la technique, à savoir la tension Vce mesurée à une température égale à 55°C et à un courant de 100A, en fonction du vieillissement de ce module, c'est-à-dire du nombre de cycles en température auquel il a été soumis.

Fig. 5b représente, pour un module IGBT, la variation relative de l'indicateur de vieillissement suivant l'invention, à savoir l'intensité I,ZCP mesurée à une tension V,ZCP égale à 1,14 V, en fonction du vieillissement de ce module, c'est-à-dire du nombre de cycles en température auquel il a été soumis.

Fig. 5c représente, pour un module IGBT, l'indicateur de vieillissement suivant l'invention I,ZCP de la figure 5b en fonction de l'indicateur de vieillissement de l'art antérieur (tension Vce) de la figure 5a.

Fig. 6 représente les variations de l'indicateur de vieillissement I,ZCP suivant l'invention en fonction de la température de mesure, cet indicateur étant mesuré à cinq valeurs de V,ZCP fixées à au plus 5% de la valeur exacte de V,ZCP, ainsi que celles de l'indicateur de vieillissement de l'art antérieur (tension Vce).

Fig. 7 représente le point ZCP d'un module IGBT portant la référence SKIM63 (300A, 1200 V) comprenant quatre puces en parallèle, obtenu pour le module non dégradé (ZCP-sain) et pour le module dégradé (ZCP-degr).

Sur les dessins, des références identiques désignent des objets identiques ou similaires.

## DESCRIPTION DÉTAILLÉE

L'invention concerne un procédé de mesure (équivalemment de suivi) de l'état de santé (ou équivalemment état d'usure ou état de dégradation) d'un composant pour l'électronique de puissance, et en particulier un composant électronique de puissance 1 à semi-conducteurs pouvant être de type bipolaire ou mixte.

L'état de santé d'un composant est déterminé par l'écart ou la dégradation de performances du composant par rapport aux performances initiales.

Les composants électroniques de puissance permettent notamment la conversion des ondes électriques (de continu en continu, de continu en alternatif et inversement, d'alternatif en alternatif) et la commande de la puissance électrique ainsi convertie au moyen de composants électroniques, c'est-à-dire d'éléments de petites dimensions devant les systèmes alimentées.

A titre d'exemple, les diodes bipolaires et les transistors bipolaires de puissance sont des composants électroniques de puissance de type bipolaire, c'est-à-dire qu'à l'état passant circulent deux types de porteurs de charge (trous et électrons).

Les transistors à grille isolée (« IGBT ») intègrent sur une même puce 13 un transistor MOS et un transistor bipolaire. Ils font partie des composants électroniques de puissance mixtes. L'architecture d'un composant électronique de puissance 1 à semi-conducteurs de type mixte est schématiquement représentée sur la figure 1.

Si les composants électroniques de puissance sont initialement configurés pour que les pertes soient faibles, les conditions auxquelles ils sont soumis au cours de leur utilisation induisent une dégradation du composant.

On distingue les modes de défaillance au niveau des puces 13 elles-mêmes des modes de défaillance au niveau de l'assemblage du composant.

La structure multicouche d'un composant électronique de puissance à semi-conducteurs est à l'origine de contraintes mécaniques aux interfaces lorsqu'il s'échauffe puis se refroidit à cause des différences de coefficients de dilatation thermiques que présentent ces différents matériaux. En particulier, des variations de température d'amplitude importante (quelques dizaines de degrés) provoquent des fissures voire des ruptures à proximité des interfaces entre les différents matériaux constituant le composant.

Les modes de défaillance au niveau de l'assemblage du composant électronique de puissance comprennent ainsi la dégradation du substrat céramique 15 isolant, la dégradation des matériaux de brasure qui permettent de lier les bornes de connexions de puissance 11 avec le substrat céramique métallisé (14 et 15), la dégradation de la brasure 17 qui permet de lier la puce au substrat céramique (14 et 15), et la dégradation des fils de liaison 12 (ou fils de « bonding ») qui assurent la connexion de la puce 13 avec les bornes de connexion de puissance 11.

Ce sont principalement ces deux derniers types de dégradation qui peuvent être diagnostiqués par le procédé de suivi de l'état de santé d'un composant électronique de puissance suivant l'invention. Ces deux types de dégradations induisent une augmentation de la résistance d'interconnexion et sont donc détectables par l'invention. On observe entre autres la levée des fils de « bonding » 12 suite à la propagation d'une fissure dans le fil à l'interface fil 12/métallisation de puce 13, ainsi que la fracture dans les pieds des fils de « bonding » 12, qui résulte de l'élongation du fil à chaque cycle de courant et est principalement due à l'auto-échauffement du fil.

Comme expliqué précédemment, les composants électroniques de puissance présentent, quel que soit leur état de santé, un point de coefficient de température nul.

Le composant électronique de puissance à semi-conducteurs comporte au moins une borne d'entrée et une borne de sortie d'un courant électrique dont l'intensité est notée I. Entre ces bornes d'entrée et de sortie s'établit une tension électrique notée V.

Le point, noté ZCP (pour « Zero Coefficient Point ») dans toute la suite, est le point d'intersection de toutes les caractéristiques statiques (I,V) à l'état passant (ou état « ON ») obtenues aux différentes températures de fonctionnement nominales pour un état de santé donné du composant. On peut observer le point ZCP sur la figure 2. Le point ZCP est défini par ses coordonnées, à savoir l'intensité du courant électrique I,ZCP et la tension V,ZCP, qui peuvent notamment être mesurées en mode continu (ou mode DC).

Le point ZCP dépend de l'état de santé du composant mais pas de la température puisque par définition, quel que soit la température dans laquelle le composant électronique de puissance se trouve, sa caractéristique statique passe par ce point.

L'état de santé du composant électronique peut ne pas varier entre deux instants successifs, ce qui signifie que le composant électronique ne s'est pas dégradé. Cet état de santé peut aussi varier entre deux instants successifs si le composant électronique a été soumis à des conditions entraînant sa dégradation.

Si l'état de santé du composant électronique est le même à deux instants ta et tb mais que la température varie, les coordonnées du point ZCP sont inchangées entre ta et tb car ce point ZCP est indépendant de la température pour un état de santé donné du composant électronique de puissance.

Pour un état de dégradation repéré par l'indicateur quantitatif D donné, le point ZCP peut être mathématiquement défini comme le point pour lequel la dérivée partielle de la fonction I (V, T, dégradation) ou équivalemment de la fonction V (I, T, dégradation) par rapport à la température est nulle :

Formule 1 :

$$\left(\frac{\partial V}{\partial T}\right)_{I,d\acute{e}gradation}(I, ZCP, D) = 0$$

Formule 2 :

$$\left(\frac{\partial I}{\partial T}\right)_{V,d\acute{e}gradation} (V, ZCP, D) = 0$$

Si l'existence du point ZCP est bien connue de l'homme du métier, son évolution au fur-et-à-mesure de l'utilisation du composant électronique de puissance n'est en revanche pas documentée. A ce jour, on observe que l'homme du métier a plutôt tendance à considérer que I,ZCP serait indépendant de la dégradation alors que V,ZCP augmenterait au cours du temps. L'invention repose sur une étude détaillée et sans préjugé de l'évolution de la position du point ZCP au cours du temps.

Cette étude a permis de montrer qu'au contraire du préjugé courant, l'intensité du courant électrique I,ZCP varie de manière significative alors que la tension V,ZCP évolue peu avec la dégradation de l'état du composant électronique de puissance.

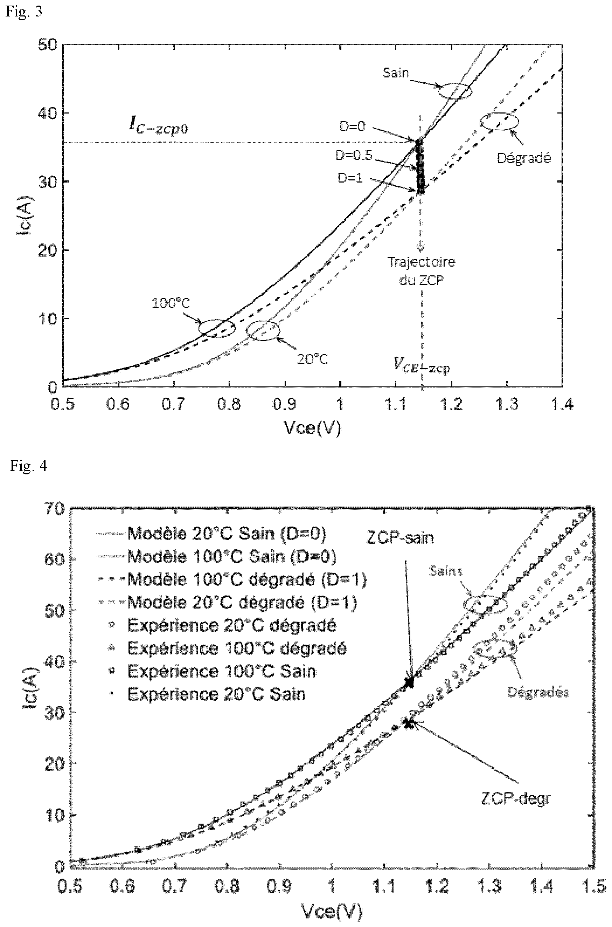

L'étude sous-tendant l'invention se base à la fois sur des mesures expérimentales, pour lesquels le composant Mitsubishi, portant la référence CMT150TX, a été soumis à 107 000 cycles d'amplitudes 90°C avec une température minimale de 35°C, au cours duquel la position du point ZCP a été régulièrement suivie en même temps que l'état de santé du composant, mesuré avec une technique conventionnelle. Dans ce cas, l'état de santé du composant a été suivi au moyen du procédé de mesure de V,ZCPO, cette grandeur étant utilisée comme indicateur de référence. Les résultats de cette étude peuvent être visualisés sur la figure 4, représentant les caractéristiques statiques courant I - tension V obtenues à plusieurs températures et correspondant aux états de santé successifs du composant électronique de puissance.

Les expériences ont été réalisées sur un module IGBT portant la référence CMT150TX de la marque Mitsubishi.

Le point d'intersection d'un faisceau de caractéristiques correspondant à un état de santé donné est le point ZCP correspondant à cet état de santé.

Ainsi, l'intersection du lieu des ronds noirs (courbe réelle sur un module sain à 20°C) et des carrés blancs bordés de noir (courbe réelle sur un module sain à 100°C) correspond au point ZCP du module sain (ZCP-sain, D=0).

L'intersection du lieu des ronds blancs cerclés de noir (courbe réelle sur un module dégradé à 20°C) et des triangles blancs bordés de noir (courbe réelle sur un module dégradé à 100°C) correspond au point ZCP du module dégradé (ZCP-degr, D=1).

L'indicateur D est un indicateur quantitatif du niveau de dégradation du module IGBT. En l'occurrence, D = 0 correspond à un module neuf (ou équivalemment sain). D = 1 correspond à une augmentation relative de 5% de l'indicateur de dégradation de référence issu de l'art antérieur. Dans ce cas, l'indicateur de référence est la tension V mesurée à une température égale à 35°C et pour un courant égal à 60 A.

Les courbes en traits plein et pointillées de la figure 4 correspondant à chacune des courbes précédentes ont été obtenues par la simulation décrite aux paragraphes suivants. Le bon accord entre les courbes réelles et les courbes simulées permet de valider à posteriori la simulation.

On remarque sur la figure 4 que le point ZCP évolue presque verticalement, et non horizontalement comme présupposé dans l'art antérieur.

Autrement dit, l'étude menée par les inventeurs montre que V,ZCP dépend peu de l'état de santé du composant alors que I,ZCP diminue de manière observable au fur-et-à-mesure que le composant de puissance se dégrade.

Ces observations expérimentales ont été confirmées par des simulations basées sur des modèles électrothermiques de la puce et de ses connexions. Un exemple de résultat de simulation est présenté sur la figure 3.

La simulation a été réalisée en modélisant la caractéristique courant-tension (Ic, Vce) à l'état passant du composant IGBT comme la somme de celle d'une diode PIN, d'un transistor MOS et de l'interconnexion due au fils de "bonding". Ce modèle est typique de ce que l'on peut rencontrer dans l'état de l'art. Le modèle utilisé est un modèle physique permettant la prise en compte de l'effet de la température ainsi que l'endommagement de l'interconnexion en introduisant une résistance de contact image du taux de dégradation.

Comme pour la figure 4, l'indicateur D est un indicateur quantitatif du niveau de dégradation du module IGBT simulé. En l'occurrence, la valeur D = 0 correspond à un module neuf (ou équivalemment sain). La valeur D = 1 correspond à une augmentation relative de 5% de l'indicateur de dégradation de référence issu de l'art antérieur. Dans ce cas, l'indicateur de référence est la tension V mesurée entre les bornes collecteur et émetteur à une température égale à 35°C et pour un courant traversant la borne collecteur d'intensité égale à 60 A.

Pour faciliter la lecture du graphique, seules les courbes correspondant à D = 1 et D = 0 ont été représentées mais les points ZCP correspondant à des valeurs de D intermédiaires ont été obtenus de la même façon.

On constate bien sur le graphique que, comme observé expérimentalement, la tension V,ZCP obtenue par la simulation est indépendante du vieillissement à la précision de la simulation. Elle est dans ce cas de l'ordre de 1,14 V.

En revanche, I,ZCP décroît significativement avec le vieillissement, d'une valeur de l'ordre de 36 A pour D = 0 à une valeur de l'ordre de 28 A pour D = 1, soit une variation relative de 22% par rapport à sa valeur initiale.

De ce fait, si V,ZCP est connu au début de la vie du composant de puissance, il est possible de proposer un procédé de suivi de l'état de santé de ce composant basé uniquement sur la connaissance de cette tension et sur la mesure de I,ZCP, ce procédé ne nécessitant à aucun moment de mesure de température.

Le composant électronique de puissance à semi-conducteurs est soumis à une fatigue thermique entrainant sa dégradation lors de son utilisation. L'utilisation du composant peut être usuelle ou intensive.

La dégradation du composant électronique de puissance concerne la dégradation des interconnexions électriques des composants, par exemple fils de connexion supérieure et/ou brasure de puce.

Le composant électronique de puissance à semi-conducteurs comporte au moins une borne d'entrée et une borne de sortie du courant et présente, dans ses caractéristiques directes courant I et tension V, un point de coefficient de température nul ZCP à l'instant t.

Suivant le type de composant électronique, les notations génériques I et V de la présente demande peuvent correspondre à différentes notations utilisées dans l'art antérieur. Notamment, dans le cas où la borne d'entrée est une borne collecteur C et la borne de sortie une borne émetteur E, l'intensité du courant pourra être notée Ic et la tension entre ces bornes Vce. Pour un composant tel qu'une diode, présentant une anode et une cathode, la tension entre la borne d'entrée anode A et la borne de sortie cathode K, la tension pourrait être notée Vak.

Le ou les composant(s) électronique(s) de puissance peut (peuvent) être installé(s) ou embarqué(s) dans un système électrique en fonctionnement.

Généralement le mot "embarqué" est réservé pour des applications mobiles ou de transport comme les véhicules, les bus, les trains, etc., et "installé" est introduit pour parler des applications stationnaires, c'est-à-dire des systèmes immobiles comme des bâtiments, des systèmes ENR, etc.

Le(s) composant(s) électronique(s) de puissance à semi-conducteurs est(sont) bipolaire(s) ou mixte(s). Le ou les composants sont par exemple un composant de puissance à IGBT, une diode, transistor, thyristor, etc.

Le procédé de mesure est capable d'indiquer l'état de santé à un instant t d'au moins un composant électronique de puissance à semi-conducteurs comportant au moins une borne d'entrée et une borne de sortie d'un courant électrique d'une intensité I entre lesquelles s'établit une tension électrique V, par exemple si le composant est soumis à une fatigue thermique entraînant sa dégradation.

Le procédé décrit dans la présente invention, utilise un capteur d'intensité de courant électrique, un capteur de tension électrique et un processeur échangeant des informations avec ces capteurs. Les capteurs recueillent les données nécessaires pour que le processeur puisse établir le point de coefficient de température nul ZCP du composant électronique de puissance étudié par le procédé.

Le point de coefficient de température nul ZCP est caractérisé par ses coordonnées (I,ZCP ; V,ZCP), qui sont indépendantes de la température.

Le procédé peut comprendre les étapes suivantes :

a- une première étape de détermination, à un instant initial t0, d'une première valeur de l'intensité I : I(t0)=I,ZCP0, lorsque la tension électrique V est égale à la tension V,ZCPO, le composant électronique de puissance étant dans un état « instant initial » ;

b- une étape de mesure d'une valeur de l'intensité I : I(ti) à un ou plusieurs instants ti ultérieurs, lorsque la tension V à l'instant ti est égale à la tension V,ZCPO, le composant électronique de puissance étant dans un état « instant ti », I(ti) étant dans ce cas égal à I,ZCP(ti) (en raison du fait que l'instant ti est défini comme un instant pour lequel la tension V(ti) est égale à la tension V, ZCPO, et que le point de coefficient de température nul ZCP est sur une verticale qui passe par V,ZCPO dans le plan courant - tension ;

c- une étape de calcul par le processeur d'un indicateur quantitatif D(ti) de la dégradation du composant électronique de puissance à chaque instant ti et dont la valeur est une fonction de la variation de la valeur de l'intensité I entre l'état « instant initial » et l'état « instant ti »

On notera que comme V,ZCP dépend peu de l'état de santé du composant, si on note V,ZCPO cette tension à l'état initial, V,ZCPO ≃ V,ZCP(ti) quel que soit l'instant ti. Fixer pour la mesure de l'intensité la tension en régime continu à la valeur V,ZCP - et donc en particulier à la valeur V,ZCPO - permet donc de s'assurer que le point de fonctionnement du composant électrique est le point de coefficient de température nul du composant à cet instant. En conséquence, l'intensité du courant électrique I(ti) dans l'état instant t correspond bien à l'intensité I,ZCP(ti) au point de coefficient de température nul du composant électronique et est bien mesurée dans ces conditions, sans qu'il soit nécessaire de faire de mesure complémentaire, notamment au moyen d'un capteur de température.

Pour déterminer la valeur de la tension V,ZCPO utilisée à l'étape a et à l'étape b, notamment lorsque cette valeur n'est pas comprise dans les données du fournisseur du composant électronique de puissance, il peut être réalisé un enregistrement de mesures "à la volée" et en fonctionnement d'une phase de variation du courant I, et de la tension V correspondante, sur une plage pour laquelle le courant passe par le point ZCP. Ce sera par exemple lors d'une phase de montée du courant ou d'une phase de descente du courant, le composant étant dans son état passant.

Par « à la volée », on entend une série de mesures successives très rapides. Ces phases peuvent durer quelques millisecondes pendant lesquelles ces enregistrements sont stockés dans la mémoire du processeur à une fréquence d'échantillonnage suffisante et adaptée à l'application, par exemple toutes les microsecondes lorsque les variations sont très rapides. Pendant ces phases, les couples de points (I,V) décrivent l'une des courbes de la figure 2 et passent donc par le point ZCP à une température donnée bien qu'inconnue. Il est nécessaire de réaliser ces mesures à deux moments différents du fonctionnement pour lesquelles les températures des composants seront différentes, par exemple au démarrage du système pour lequel la température sera basse et après un petit moment de fonctionnement pour lequel le composant sera dans un état de température plus élevé. La recherche du point d'intersection des deux portions de courbes ainsi obtenues à l'aide d'un processeur déterminera le point ZCP à l'état initial. Il n'est pas nécessaire de réguler ou de fixer une température de fonctionnement. Il n'est pas nécessaire de connaître la valeur de la température de fonctionnement pour obtenir le point ZCP. Bien que cela soit possible, il ne sera pas nécessaire de reproduire ces mesures en dehors de l'état initial (t0).

Le composant électronique de puissance passe spontanément, au cours de son utilisation, très fréquemment dans un état de type « instant ti » pour lequel la tension électrique V est égale à V,ZCPO. Il suffit pour cela de ne conserver et ne traiter que les mesures réalisées aux états "instants ti" durant des phases typiques de fonctionnement du composant l'amenant à passer par ces états et détectables au fait que la tension passe par V,ZCPO ou à son voisinage. A titre d'exemple, un composant électronique de puissance de type IGBT utilisé dans un ascenseur passe dans un état de type instant ti pour chaque phase d'accélération ou encore durant chaque phase de décélération, soit jusqu'à plusieurs dizaines voire centaines de fois par jour. En conséquence, il suffit d'effectuer des mesures de la tension V de manière répétée, par exemple durant des phases bien choisies (par exemple la phase d'accélération de l'exemple précédent), avec un temps caractéristique de répétition des mesures (dit temps d'échantillonnage) choisi de manière à ce que :

- soit l'état « instant ti » soit atteint pour au moins une mesure de tension V, l'intensité étant dans ce cas elle aussi mesurée au même instant, et ce sans choix particulier des dates auxquelles les mesures de V sont répétées,
- soit l'état « instant ti » soit atteint transitoirement entre au moins deux dates de mesure t1 et t2 successives de la tension V, de sorte que par interpolation entre ces deux dates de mesure successives, il est possible de reconstituer les informations sur l'état instant ti, ti étant compris entre t1 et t2. Par exemple, si on réalise une interpolation linéaire, ti peut être déduit de la relation :

Formule 3 :

$$\frac{V,ZCP0 - V(t1)}{V(t2) - V(t1)} = \frac{ti - t1}{t2 - t1}$$

dans la mesure où par définition de l'état instant ti, V(t1)=V,ZCP0.

Dans ce même cas, on a alors, si on réalise une interpolation linéaire :

Formule 4 :

$$\frac{I,ZCP(ti) - I(t1)}{I(t2) - I(t1)} = \frac{ti - t1}{t2 - t1}$$

D'autres types d'interpolations de types "non-linéaires", quadratiques par exemple, peuvent être envisagés. Le choix de la méthode d'interpolation peut dépendre de la précision à laquelle la tension V,ZCP doit être mesurée.

Au vu des variations de la tension V et de l'intensité I dans les composants électroniques de puissance courants dans les conditions d'utilisation courantes, il est possible avec la méthode décrite ci-dessus de définir de nombreuses paires (t1,t2) par exemple quotidiennement.

Il est possible de réaliser des mesures de courant et tension de manière continue et de n'enregistrer et ne traiter que les valeurs pour lesquelles la tension V passe par V,ZCPO ou à son voisinage. De la sorte, aucune stratégie de choix des instants ti n'est nécessaire, mis à part le choix de la durée caractéristique de l'intervalle de temps entre deux instants ti successifs quelconques pour le suivi de l'état de santé de ce composant.

A titre d'exemple non limitatif, pour un composant IGBT usuel, le temps entre deux mesures successives (temps dit d'échantillonnage) peut aller de la milliseconde ($10^{-3}$ secondes, 1 ms) à la dizaine de microsecondes ($10^{-5}$ secondes, 10 μs) suivant la vitesse d'acquisition des mesures disponible par l'appareil de mesure. Ainsi, entre deux mesures successives la tension évolue peu et l'interpolation est tout à fait possible. Un temps d'échantillonnage aussi court peut ne pas permettre de stocker toutes les données de mesure. Dans ce cas, on ne stocke les résultats de mesure (par exemple dans une mémoire de stockage) que lorsque V passe dans une fenêtre au voisinage de VZCP (de manière croissante ou décroissante)

Dans un autre mode de réalisation, on peut choisir de définir le ou les instants ti a priori. Par exemple, les instants ti peuvent être choisis sur des plages dans lequel le composant électronique de puissance n'est pas sollicité pour son utilisation nominale, par exemple typiquement lorsqu'un dispositif dans lequel le composant électronique de puissance est embarqué n'est pas utilisé, ou est inactif. Dans ce mode de réalisation, on pourra prévoir d'imposer à la tension V de prendre à l'instant ti la valeur V,ZCPO, notamment au moyen d'un générateur de tension, de façon à placer volontairement le composant électronique de puissance dans un état de type « instant ti ».

Dans un mode réalisation possible, le procédé de mesure n'utilise aucun capteur de température ni aucune estimation de température pour effectuer les étapes a, b et c précédemment décrites. Avantageusement, aucun capteur de température n'est utilisé durant tout le procédé.

Dans un mode de réalisation possible, le procédé de mesure comprend deux étapes préalables avant l'étape a :

i- une étape comprenant au moins deux séries de mesures de l'intensité de courant électrique I par le capteur d'intensité de courant électrique et de la tension électrique V par le capteur de tension électrique, les séries de mesures (I,V) étant prises à des températures différentes ;

ii- une étape de calcul par le processeur, d'une valeur de tension électrique V,ZCPO et d'une valeur de courant électrique I,ZCP0 au point de coefficient de température nul ZCP, à partir des mesures de l'étape i, le point de coefficient de température nul ZCP étant le point de croisement des deux séries de mesures (I, V) de l'étape i , l'intensité I,ZCP(t0) et la tension V,ZCP(t0) à l'état « instant initial » étant égales respectivement à I,ZCP0 et V,ZCPO.

Ces deux étapes préalables peuvent être réalisées sur le composant électronique de puissance à l'état neuf ou à un état initial différent de l'état neuf, par exemple un état initial pour lequel le composant électronique peut être considéré comme non dégradé.

Les au moins deux températures différentes ne sont pas nécessairement déterminées. Dans un mode de réalisation particulier, les températures ne sont pas quantifiées durant le procédé.

Ces étapes préalables et/ou les étapes du procédé peuvent être réalisées in situ, une fois le composant électronique de puissance installé ou embarqué dans un système électrique en fonctionnement, ou avant la mise en place définitive du composant électronique. Il est possible également d'utiliser directement les fiches constructeurs ("datasheet") des composants où les points de croisement ZCP sont donnés.

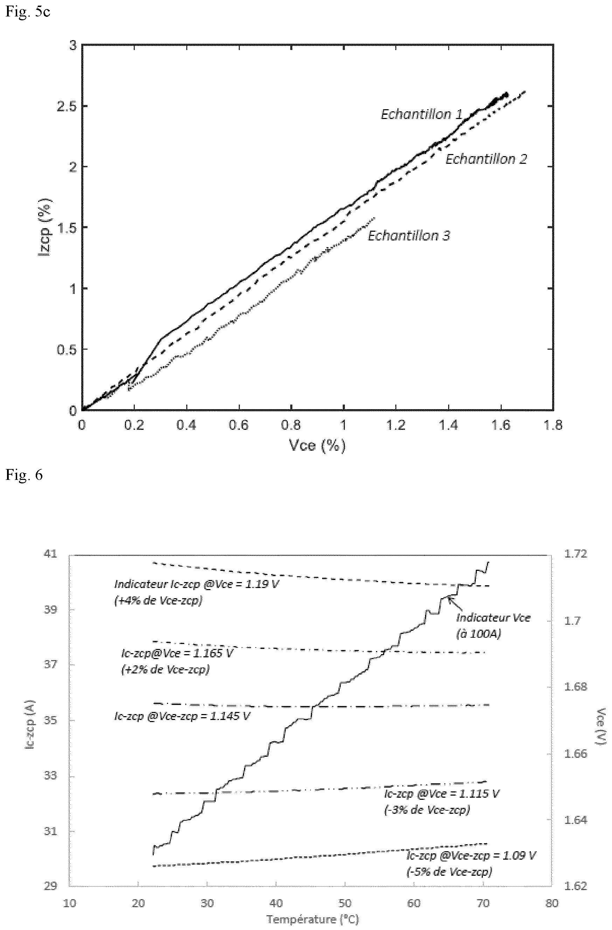

On peut notamment observer sur le graphique de la figure 6 qu'à dégradation constante, la variation relative de l'indicateur I,ZCP dans la gamme de température [20°C, 70°C] n'excède pas 0,2% à Vce,ZCP (en l'occurrence 1.145 V) (à comparer à des variations de l'ordre de quelques pourcents pour conclure sur le vieillissement) alors que l'indicateur Vce de l'art antérieur présente des variations relatives de l'ordre de 5% (variation de Vce pour Ic= 100A : de 1.63V à 1.717V, soit 5.3% de variation), soit des variations relatives de l'ordre de celles qui sont exploitées pour conclure sur le vieillissement.

Sur ce graphique, on constate en outre qu'une imprécision sur la mesure de Vce,ZCP à laquelle Ic,ZCP est déterminée n'impacte la valeur de Ic,ZCP que de manière modérée.

Les gammes de variations de l'indicateur Ic,ZCP pour une variation de la température de 22°C à 71°C sont en effet les suivantes:

- Variation de Ic,ZCP pour Vce =1.19V (+4% par rapport à Vce,ZCP) : de 40.7A à 39.86A, soit 2% de variation ;
- Variation de Ic,ZCP pour Vce = 1.165V (+2% par rapport à Vce,ZCP) : de 37.84A à 37.44A, soit 1% de variation ;
- Variation de Ic,ZCP pour Vce = 1.145V (= Vce,ZCP) : de 35.61A à 335.55A, soit 0.17% de variation ;
- Variation de Ic,ZCP pour Vce = 1.115V (-3 % par rapport à Vce,ZCP) : de 32.36A à 32.79A, soit 1.3% de variation ;
- Variation de Ic,ZCP pour Vce = 1.09V (-5 % par rapport à Vce,ZCP) : de 29.75A à 30.55A, soit 2.6% de variation.

On comprend donc que la connaissance de la température est critique pour l'indicateur de dégradation de l'art antérieur mais n'est pas nécessaire pour l'indicateur de dégradation suivant l'invention

Le procédé ne nécessite pas non plus de procéder à une série de mesures pour obtenir l'état de santé correspondant à l'instant t, dont le but serait de tracer un faisceau de caractéristiques à différentes températures de manière à en déduire la position du point ZCP. Il suffit simplement de déterminer une première fois la tension V,ZCP, de manière à connaître la valeur de référence V,ZCPO pour l'étape a du procédé, par exemple avant la mise en place du composant électronique de puissance dans un système qui l'embarque ou par exemple au moyen des données fournies par le fabricant.

On pourra aussi remarquer sur ce graphique qu'il n'est pas indispensable de déterminer et/ou de fixer V,ZCP avec une précision très élevée pour mettre en œuvre le procédé suivant l'invention. Notamment, une imprécision de 5% sur V,ZCP se traduit par une variation relative de I,ZCP avec la température d'au maximum 1,5% dans la gamme de température [45°C, 65°C], V,ZCP ayant été déterminée à 55°C.

La mesure de la tension électrique V,ZCPO pour l'étape b du procédé est fixée à une précision relative qui peut dépendre du type du composant électronique de puissance et qui peut notamment avoir une valeur inférieure à 5%, c'est-à-dire qu'à l'instant t1, la tension électrique V est égale à V,ZCPO à + ou - 5% près.

La précision avec laquelle V,ZCP est déterminée et/ou fixée pour mettre en œuvre le procédé pourra donc être adaptée à la précision nécessaire sur l'indicateur de dégradation, mais avantageusement une précision inférieure à 5% permet d'obtenir des résultats satisfaisants sans nécessiter la mise en œuvre de dispositifs coûteux et/ou complexes.

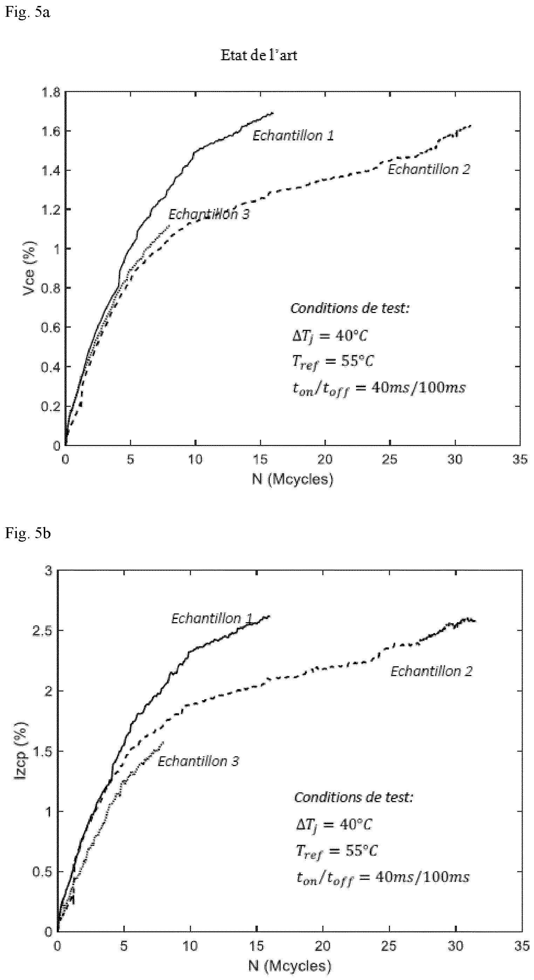

La figure 5a représente, pour trois modules IGBT portant la même référence CMT150TX de la marque Mitsubishi, la variation relative d'un indicateur de dégradation de l'art antérieur, à savoir la tension Vce mesurée à une température égale à 55°C et à un courant de 60A, en fonction de la dégradation de ce module, c'est-à-dire du nombre de cycles en température auquel il a été soumis.

Trois modules différents ont été testés (échantillon 1, échantillon 2, échantillon 3) dans la mesure où la dégradation de ces composants électroniques présente un caractère aléatoire, de sorte que des disparités dans la dégradation peuvent apparaître pour deux composants d'un même lot par exemple.

La figure 5b représente, pour les mêmes modules IGBT, la variation relative de l'indicateur de dégradation suivant l'invention, à savoir l'intensité I,ZCP mesurée à une tension V,ZCP égale à 1,14V en fonction de la dégradation de ce module, c'est-à-dire du nombre de cycles en température auquel chaque module a été soumis.

La figure 5c représente, toujours pour les mêmes modules IGBT, l'indicateur de dégradation suivant l'invention I,ZCP de la figure 5b en fonction de l'indicateur de dégradation de l'art antérieur (tension Vce) de la figure 5a.

En d'autres termes, une courbe de la figure 5c représente la correspondance entre les résultats obtenus sur la variation relative du nouvel indicateur I,ZCP et celui de l'état de l'art Vce, au fur et à mesure de la progression des dégradations.

On constate sur cette figure qu'il existe une bijection entre I,ZCP(t) et V,ZCP (t). Si l'on admet que V,ZCP (t) est un indicateur satisfaisant de l'état de vieillissement du composant, I,ZCP(t) est donc lui aussi un indicateur satisfaisant de cet état de dégradation.

En revanche, on constate que I,ZCP(t) est pratiquement une fonction linéaire de V,ZCP(t), de pente supérieure à 1. La sensibilité de I,ZCP(t) est donc meilleure que celle de V,ZCP(t), en l'occurrence d'un facteur 1,5 à 2.

On comprend donc que le procédé suivant l'invention est particulièrement avantageux, puisqu'il permet non seulement de se passer de capteur de température, mais qu'il fournit aussi un indicateur de l'état de santé du composant plus sensible, qui permettra de bâtir une stratégie de maintenance des systèmes embarquant le composant électronique de puissance avec des intervalles de confiance améliorés.

La simplicité du procédé permet sa mise en œuvre in situ, pour obtenir un diagnostic de l'état de santé d'un composant en temps réel.

L'indicateur D(ti) de l'état de santé du composant électronique à l'instant ti peut être déduit de I,ZCP(ti) par exemple par une comparaison avec I,ZCP(t0). Ainsi, on peut calculer le rapport de I,ZCP(ti) et de I,ZCP(t0) ou la variation absolue ou relative de I entre l'état « instant initial » et l'état « instant ti », soit en d'autres termes la variation absolue ou relative de I,ZCP entre t=0 et t=ti puisque I(t=0) est par définition de l'état « instant initial » égal à I,ZCP(t0) et I(ti) est par définition de l'état « instant initial » égal à I,ZCP(ti).

Dans ce cas, il est possible de fixer un seuil absolu ou relatif, dépendant du modèle du composant électronique ou propre à un composant électronique donné, en fonction du niveau d'exigence fixé pour le diagnostic.

Par exemple, on considère communément qu'un composant électronique dont l'indicateur de vieillissement de l'état de l'art, qui est la tension mesurée à un courant et à une température fixée, a varié de 5% par rapport au composant neuf est dégradé. Compte tenu de la meilleure sensibilité de l'indicateur I,ZCP(ti), on pourra, pour obtenir un diagnostic équivalent, considérer que le remplacement du composant est nécessaire si I,ZCP(ti) a subi une diminution relative de 8 % à 10% par rapport à l'état neuf.

Il est aussi possible de calculer un indicateur quantitatif D(ti) de l'état de santé du composant en calculant le rapport de la différence (I,ZCP(ti) - I,ZCP(initial)) et de la différence (I,ZCP(final) - I,ZCP(initial)) où I,ZCP(final) est considéré comme la valeur atteinte lorsque le niveau de dégradation du composant nécessite par exemple son remplacement et I,ZCP(initial) correspond au composant sain.

Dans ce cas l'indicateur de dégradation est nul pour un composant sain et égal à 1 pour le composant à remplacer.

1,ZCP(initial) peut notamment être mesuré sur un composant représentatif du composant sur lequel le procédé est mis en œuvre, par exemple un composant portant la même référence fournisseur.

On pourra, dans le cadre d'un suivi en temps réel, répéter de manière itérative, par exemple périodique, la mesure de l'intensité du courant électrique du collecteur I,ZCP(ti) à l'instant ti au point de coefficient de température nul du composant électronique et la déduction de l'indicateur quantitatif D(ti) de l'état de santé du composant électronique.

Le procédé peut s'appliquer à des composants électroniques individuels (diode, module IGBT) ou à des associations de composants électroniques mixtes et/ou bipolaires utilisés dans les systèmes de conversion d'énergie tels que des onduleurs.

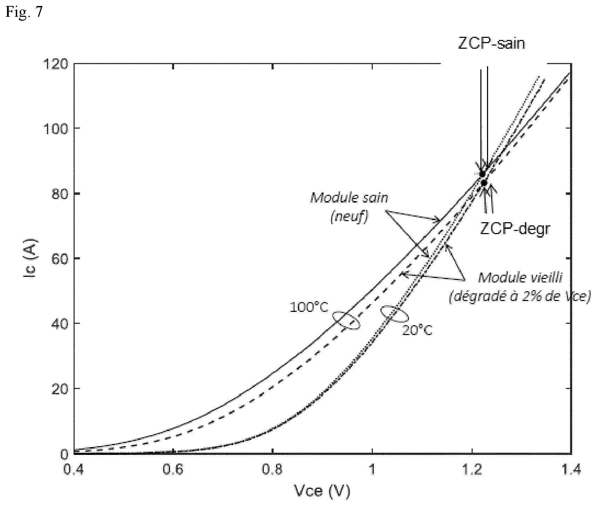

On peut le constater sur la figure 7, représentant le point ZCP d'un module IGBT portant la référence SKIM63 (300A, 1200 V) comprenant quatre puces en parallèle, obtenu pour le module non dégradé (ZCP-sain) et pour le module dégradé (ZCP-degr), la dégradation correspondant dans ce cas à une diminution relative de 2% de l'indicateur de dégradation de l'art antérieur Vce, mesurée à une température égale à 55°C.

Les points ZCP-sain et ZCP-degr sont bien à la verticale l'un de l'autre, c'est-à-dire qu'ils correspondent à la même tension V,ZCP alors que I,ZCP varie significativement.

Plus précisément, entre les points ZCP-sain et ZCP-degr, V,ZCP varie de 1,2209 V à 1,2243 V, soit une variation relative de 2,8‰ (pour mille), alors que I,ZCP varie de 85,7152 A à 83,4417 A soit une variation relative de 2,7% (pour cent) soit une variation de l'ordre de 10 fois plus importante que celle de V,ZCP.

On constate encore une fois que l'indicateur de dégradation suivant l'invention est non seulement plus facile à mettre en œuvre que les indicateurs de l'art antérieur puisqu'ils ne nécessitent pas de connaître la température, mais aussi plus sensible : dans le cas de la figure 7, I,ZCP subit une variation relative de 2,7% alors que l'indicateur de vieillissement de l'art antérieur Vce ne subit une variation relative que de 2%.

Dans les associations de composants électroniques, le cyclage de température au niveau de chaque composant est dû non seulement à l'auto-échauffement de ce composant mais aussi aux échauffements des composants voisins. Il y a donc un couplage des dégradations des composants individuels, de sorte qu'il peut être pertinent de suivre l'état de santé de l'association dans son ensemble.

Dans ce dernier cas, on met en œuvre un ou plusieurs capteurs de tension ; un ou plusieurs capteurs d'intensité répartis en fonction de la nature des associations électriques (série, parallèle). Par exemple, pour le suivi de l'état de santé d'un onduleur, on peut dédier un capteur de tension à chaque puce, ainsi qu'un capteur de courant à chaque bras d'onduleur.

La description concerne aussi un dispositif de mesure pour mettre en œuvre le procédé de mesure de l'état de santé d'un composant électronique de puissance à semi-conducteurs comportant au moins une borne d'entrée et une borne de sortie du courant électrique d'une intensité I, entre lesquelles s'établit une tension électrique V, le composant électronique présentant un point de coefficient de température nul ZCP indépendant de la température, suivant l'un quelconque des modes de réalisation décrits plus haut.

Le dispositif de mesure comprend au moins un capteur d'intensité électrique permettant de mesurer l'intensité I du courant électrique I,ZCP traversant la borne d'entrée (ou la borne de sortie) à un instant quelconque.

Dans un mode de réalisation, le dispositif de mesure comprend aussi un capteur de tension électrique permettant de mesurer la tension électrique s'établissant entre les bornes d'entrée et de sortie du composant électronique de puissance.

Dans un mode de réalisation particulier, le dispositif de mesure comprend aussi un processeur qui échange des données avec le capteur d'intensité et /ou le capteur de tension.

Les capteurs de tension et d'intensité peuvent être configurés pour la mise en œuvre des étapes suivantes :

a- une première étape de détermination , à un instant initial t0, d'une première intensité I,ZCP(t0) lorsque la tension V est égale à une tension V,ZCPO, le composant électronique de puissance étant dans un état « instant initial »
b- une étape de mesure d'une intensité I,ZCP(ti) à un ou plusieurs instants ti ultérieurs, lorsque la tension V à chaque instant ti est égale à la tension V,ZCPO, le composant électronique de puissance étant alors dans un état « instant ti » ;
c- une étape de calcul par le processeur d'un indicateur quantitatif D(ti) de la dégradation du composant électronique de puissance pour chaque instant ti et dont la valeur est une fonction de la variation de la valeur de l'intensité I,ZCP(ti) entre l'état « instant initial » et l'état « instant ti »

Dans un mode de réalisation particulier du dispositif de mesure, l'au moins un composant électronique de puissance à semi-conducteurs est de type bipolaire ou mixte.

Dans un mode de réalisation particulier, le dispositif de mesure est une puce connectée au composant électronique de puissance.

Dans un mode de réalisation particulier, le dispositif de mesure est un dispositif portatif et externe au composant électronique, permettant notamment la mesure de l'état de dégradation pour un composant, puis le dispositif pouvant être débranché de ce premier composant afin d'être branché à un second composant.

Avantageusement, le composant électronique possède un traceur de caractéristiques si le composant électronique est extrait de son système, c'est-à-dire isolé de son environnement.

La description concerne aussi un module électronique de puissance intégrant un mode de réalisation possible du dispositif de mesure décrit précédemment, le dispositif de mesure étant utilisé pour un ou plusieurs composants électroniques en parallèle et/ou en série.

Dans un mode de réalisation particulier, le dispositif de mesure équipe un module électronique de puissance comprenant au moins deux composants électroniques en parallèle et/ou en série et le dispositif de mesure permet de suivre l'état de santé d'un ou de plusieurs ou de chacun des composants électroniques de puissance du module électronique.

La description concerne également un système embarquant : un ou plusieurs modules décrits précédemment et un dispositif de mesure pour un ou plusieurs de ces modules. Chaque dispositif de mesure fournit un indicateur de dégradation d'un ou de plusieurs des composants électroniques de puissance à semi-conducteurs du module qu'il équipe, voire de l'ensemble du module. L'indicateur est obtenu par le procédé de mesure compris dans les modules.

Dans une réalisation particulière, le système embarquant est un système de transports électrique tel que des véhicules électriques, trains, métros, tramways, vélos, motos, bus, ascenseurs, tapis roulants, escaliers mécaniques, etc.

Dans une autre réalisation particulière, le système embarquant est un système de gestion de l'énergie électrique et/ou de conversion d'énergie électrique pour les énergies renouvelables, tel que des systèmes éoliens, marins, solaires, etc.

Dans une réalisation particulière, le système embarquant est un système stationnaire tel que des bornes de recharges pour voitures électriques, des variateurs de vitesse, des alimentations à découpage, du chauffage par induction, de la récupération d'énergie électrique, etc.

La description porte aussi sur un programme de calcul comprenant des instructions de code de programme pour l'exécution des étapes du procédé de mesure de l'état de santé d'un composant électronique de puissance à semi-conducteurs décrit selon une réalisation possible lorsque le programme est exécuté par un processeur.

Avantageusement, le processeur est embarqué et est une puce pouvant faire des calculs. Par exemple, la puce est de type FPGA.

Dans une réalisation particulière, le procédé de mesure de l'état de santé du programme de calcul est appliqué au système embarquant un ou plusieurs modules précédemment décrit ; si le procédé de mesure renvoie un indicateur quantitatif de dégradation signalant une dégradation, le programme de calcul applique le procédé de mesure à chaque composant électronique de puissance à semi-conducteurs du système embarquant. Le programme de calcul est appliqué en premier lieu pour évaluer le système dans sa globalité, le programme de calcul est appliqué dans un second temps pour identifier les composants qui commencent à se dégrader.

## LISTE DES SIGNES DE RÉFÉRENCE

1 : module IGBT
11 : bornes de connexion de puissance
12 : fil de « bonding »
13 : puce en Silicium
14 : couche de cuivre
15 : couche de matériau céramique
16 : support du boitier (ou semelle)
17: brasure de la puce

**Revendications**

1. Procédé de mesure de l'état de santé à plusieurs instants ti d'au moins un composant électronique de puissance à semi-conducteurs par le calcul d'un indicateur quantitatif D(ti) de la dégradation du composant électronique de puissance, pour déterminer l'évolution du vieillissement dudit composant électronique de puissance,

   le composant électronique de puissance comportant au moins une borne d'entrée et une borne de sortie d'un courant électrique d'une intensité I, entre lesquelles s'établit une tension électrique V,
   le composant électronique de puissance présentant un point de coefficient de température nul ZCP défini par une intensité du courant électrique I,ZCP et une tension V,ZCP, ZCP étant indépendant de la température,
   le procédé utilisant un capteur d'intensité de courant électrique, un capteur de tension électrique et un processeur échangeant des informations avec lesdits capteurs,
   le procédé comprenant :

      a- une première étape de détermination, à un instant initial t0, d'une première valeur de l'intensité I(t0) =I,ZCP0 lorsque la tension électrique V est égale à une tension V(t0) = V,ZCPO, le composant électronique de puissance étant alors dans un état « instant initial » ;
      b- une étape de mesure d'une valeur de l'intensité I à chaque instant ti ultérieur, lorsque la tension V à l'instant ti du composant électronique de puissance est égale à la tension V,ZCPO, le composant électronique de puissance étant alors dans un état « instant ti » ;

c- une étape de calcul par le processeur d'un indicateur quantitatif D(ti) du vieillissement du composant électronique de puissance à chaque instant ultérieur ti et dont la valeur est une fonction de la variation de la valeur de l'intensité I entre l'état « instant initial » et l'état « instant ti », le vieillissement étant indépendant de la tension V,ZCP mais dépendant de l'intensité I,ZCP qui décroît avec le vieillissement.

2. Procédé de mesure suivant la revendication 1, comprenant une mesure de l'intensité I,ZCP(ti) lorsque la tension en régime continu est à la valeur V,ZCPO, où l'intensité du courant électrique I(ti) dans l'état instant ti correspond à l'intensité I,ZCP(ti) au point de coefficient de température nul du composant électronique, la mesure étant faite sans qu'il ne soit nécessaire de faire de mesure complémentaire, notamment au moyen d'un capteur de température.

3. Procédé de mesure suivant l'une des revendications 1 et 2, dans lequel aucun capteur de température n'est mis en œuvre ni aucune estimation de température n'est nécessaire pour les étapes a, b et c, l'indicateur quantitatif D(ti) de la dégradation du composant électronique étant indépendant de la température.

4. Procédé de mesure suivant l'une des revendications 1 à 3, dans lequel le procédé de mesure comprenant avant l'étape a :

i- une étape comprenant au moins deux séries de mesures de l'intensité de courant électrique I par le capteur d'intensité de courant électrique et de la tension électrique V par le capteur de tension électrique, les séries de mesures (I,V) étant prises à des températures différentes ;
ii- une étape de calcul par le processeur, de la valeur de tension électrique V,ZCPO et de la valeur de courant électrique I,ZCP0 au point de coefficient de température nul ZCP, à partir des mesures de l'étape i, le point de coefficient de température nul ZCP étant le point de croisement des deux séries de mesures (I, V) de l'étape i, l'intensité I(t0) et la tension V(t0) à l'état « instant initial » étant égales respectivement à I,ZCP0 et V,ZCPO.

5. Procédé de mesure suivant l'une quelconque des revendications 1 à 4, dans lequel l'au moins un composant électronique de puissance à semi-conducteurs, est embarqué ou installé dans un système électrique en fonctionnement, le procédé de mesure de l'état de santé du composant étant réalisé en exploitation du système électrique.

6. Procédé de mesure suivant l'une quelconque des revendications 1 à 5, dans lequel la mesure de la tension électrique V(ti) est effectuée à l'étape b avec une précision relative qui dépend du type du composant électronique de puissance, cette précision relative ayant une valeur inférieure à 5%.

7. Procédé de mesure suivant l'une quelconque des revendications 1 à 6, dans lequel la dégradation concerne la dégradation des interconnexions électriques des composants.

8. Procédé de mesure suivant l'une des revendications 1 à 7, dans lequel, l'état de santé correspondant à l'instant ti dans l'étape c) est obtenu sans procéder à une série de mesures dont le but serait de tracer un faisceau de caractéristiques à différentes températures de manière à en déduire la position du point ZCP, où le point d'intersection du faisceau de caractéristiques correspondant à un état de santé donné est le point ZCP correspondant audit état de santé, la tension V, ZCP étant déterminée une première fois pour obtenir la tension V,ZCPO de sorte à mettre en œuvre l'étape a) dudit procédé.

9. Procédé de mesure suivant l'une quelconque des revendications 1 à 8, dans lequel l'indicateur D(ti) de l'état de santé du composant électronique à l'instant ti est déterminé par une comparaison de l'intensité à l'instant ti I,ZCP(ti) avec l'intensité à l'instant initial I,ZCP(t0).

10. Procédé de mesure suivant l'une quelconque des revendications 1 à 9, dans lequel l'indicateur quantitatif D(ti) de l'état de santé du composant à l'instant ti est déterminé en calculant le rapport de la différence de l'intensité à l'instant ti I,ZCP(ti) et de l'intensité à l'instant initial I,ZCP(t0) et de la différence de l'intensité à un instant final I,ZCP(tfinal) et de l'intensité à l'instant initial I, ZCP(t0) où l'intensité à l'instant final I,ZCP(tfinal) est la valeur atteinte lorsque le niveau de dégradation du composant nécessite son remplacement et où l'intensité à l'instant initial I,ZCP(t0) correspond à l'intensité du composant en état sain.

11. Dispositif de mesure de l'état de santé à un ou plusieurs instants ti d'au moins un composant électronique de puissance à semi-conducteurs par le calcul d'un indicateur quantitatif D(ti) de la dégradation du composant électronique de puissance, pour déterminer l'évolution du vieillissement dudit composant électronique de puissance,

le dispositif de mesure comportant au moins une borne d'entrée et une borne de sortie du courant électrique d'une intensité I, entre lesquelles s'établit une tension électrique V, le composant électronique de puissance présentant un point de coefficient de température nul ZCP défini par une intensité du courant électrique I,ZCP et une tension V,ZCP, ZCP étant indépendant de la température,

le dispositif comprenant un capteur d'intensité de courant électrique, un capteur de tension électrique et un processeur échangeant des informations avec lesdits capteurs, configurés pour la mise en œuvre des étapes suivantes :

a- une première étape de détermination, à un instant initial t0, d'une première intensité I(t0) = I,ZCP0, lorsque la tension V est égale à une tension V(t0)=V,ZCP0, le composant électronique de puissance étant dans un état « instant initial » ;

b- une étape de mesure d'une valeur de l'intensité I à chaque instant ti ultérieur, lorsque la tension V à l'instant ti est égale à la tension V,ZCPO, le composant électronique de puissance étant dans un état « instant ti » ;

c- une étape de calcul par le processeur d'un indicateur quantitatif D(ti) du vieillissement du composant électronique de puissance à chaque instant ultérieur ti et dont la valeur est une fonction de la variation de la valeur de l'intensité I entre l'état « instant initial » et l'état « instant ti », le vieillissement étant indépendant de la tension V,ZCP mais dépendant de l'intensité I,ZCP qui décroît avec le vieillissement.

12. Dispositif de mesure selon la revendication 11, **caractérisé en ce que** l'au moins un composant électronique de puissance à semi-conducteurs est bipolaire ou mixte.

13. Module électronique de puissance intégrant un dispositif de mesure selon l'une des revendications 11 à 12 pour au moins deux composants électroniques en parallèle et/ou série.

14. Système embarquant un ou plusieurs modules électroniques de puissance selon la revendication 13, le dispositif de mesure de l'état de santé d'au moins un composant électronique de puissance intégré dans chaque module fournissant un indicateur quantitatif de dégradation.

15. Système embarquant un ou plusieurs modules électroniques de puissance selon la revendication 14, le système étant un système de gestion de l'énergie électrique et/ou de conversion d'énergie électrique pour les énergies renouvelables ou un système de transports à traction électrique ou un système stationnaire.

16. Programme de calcul comprenant des instructions de code de programme pour l'exécution des étapes du procédé de mesure de l'état de santé d'un composant électronique de puissance à semi-conducteurs selon l'une quelconque des revendications 1 à 10 lorsque ledit programme est exécuté par le dispositif de la revendication 11.

17. Programme de calcul selon la revendication 16, dans lequel le procédé de mesure de l'état de santé est appliqué au système embarquant un ou plusieurs modules électroniques de puissance selon l'une quelconque des revendications 14 à 15, dans lequel si le procédé de mesure renvoie un indicateur quantitatif de dégradation supérieur à une valeur seuil prédéterminée, le programme de calcul applique le procédé de mesure à chaque composant électronique de puissance à semi-conducteurs du système embarquant un ou plusieurs modules électroniques de puissance.

**Patentansprüche**

1. Verfahren zur Messung des Gesundheitszustands zu mehreren Zeitpunkten ti mindestens eines elektronischen Leistungsbauelements in Festkörperbauweise durch Berechnung eines quantitativen Indikators D(ti) für die Degradation des elektronischen Leistungsbauelements, um die Entwicklung der Alterung des elektronischen Leistungsbauelements zu bestimmen, wobei das elektronische Leistungsbauelement mindestens einen Eingangsanschluss und einen Ausgangsanschluss für einen elektrischen Strom der Stärke I umfasst, zwischen denen eine Spannung V aufgebaut wird,

wobei das Leistungselektronikbauteil einen Null-Temperaturkoeffizienten-Punkt ZCP aufweist, der durch eine elektrische Stromstärke I,ZCP und eine Spannung V,ZCP definiert ist, wobei ZCP unabhängig von der Temperatur ist,

wobei das Verfahren einen elektrischen Stromsensor, einen elektrischen Spannungssensor und einen Prozessor verwendet, der Informationen mit den Sensoren austauscht,

wobei das Verfahren umfasst:

a- einen ersten Schritt des Bestimmens, zu einem Anfangszeitpunkt t0, eines ersten Wertes des Stroms I(t0) =I, ZCPO, wenn die elektrische Spannung V gleich einer Spannung V(t0)=V, ZCP0 ist, wobei das Leistungselektronikbauteil dann in einem "Anfangsaugenblicks"-Zustand ist; b) einen Schritt des Messens eines Wertes des Stroms I zu jedem nachfolgenden Zeitpunkt ti, wenn die Spannung V zum Zeitpunkt ti des Leistungselektronikbauteils gleich der Spannung V,ZCPO ist, wobei das Leistungselektronikbauteil dann in einem "Augenblicks ti"-Zustand ist;

c) einen Schritt, in dem der Prozessor einen quantitativen Indikator D(ti) der Alterung der Leistungselektronikkomponente zu jedem nachfolgenden Zeitpunkt ti berechnet, dessen Wert eine Funktion der Änderung des Wertes des Stroms I zwischen dem Zustand "Anfangszeitpunkt" und dem "Zeitpunkt ti" ist, wobei die Alterung unabhängig von der Spannung V,ZCP ist, aber von der Intensität I,ZCP abhängt, die mit der Alterung abnimmt.

2. Messverfahren nach Anspruch 1, das eine Messung der Stromstärke I,ZCP(ti) umfasst, wenn die Gleichspannung den Wert V,ZCPO hat, wobei die elektrische Stromstärke I(ti) im Moment ti der Stromstärke I,ZCP(ti) am Punkt des Temperaturkoeffizienten Null des elektronischen Bauteils entspricht, wobei die Messung durchgeführt wird, ohne dass es notwendig ist, irgendeine zusätzliche Messung durchzuführen, insbesondere mittels eines Temperatursensors.

3. Messverfahren nach einem der Ansprüche 1 und 2, bei dem kein Temperatursensor verwendet wird und keine Temperaturschätzung für die Schritte a, b und c erforderlich ist, wobei der quantitative Indikator D(ti) der Verschlechterung des elektronischen Bauteils unabhängig von der Temperatur ist.

4. Messverfahren nach einem der Ansprüche 1 bis 3, bei dem das Messverfahren vor dem Schritt a: i- einen Schritt, der mindestens zwei Messreihen der elektrischen Stromstärke I durch den elektrischen Stromstärkesensor und der elektrischen Spannung V durch den elektrischen Spannungssensor umfasst, wobei die Messreihen (I, V) bei unterschiedlichen Temperaturen durchgeführt werden; ii- einen Schritt der Berechnung des elektrischen Spannungswerts V, ZCP0 und des elektrischen Stromwerts I, ZCP0 am Nullpunkt des Temperaturkoeffizienten ZCP durch den Prozessor auf der Grundlage der Messungen aus Schritt i, wobei der Nullpunkt des Temperaturkoeffizienten ZCP der Schnittpunkt der beiden Messreihen (I, V) aus Schritt i ist, wobei der Strom I(t0) und die Spannung V(t0) im Zustand "Anfangsaugenblick" gleich I,ZCP0 bzw. V,ZCPO sind.

5. Messverfahren nach einem der Ansprüche 1 bis 4, bei dem das mindestens eine Leistungshalbleiter-Elektronikbauteil in ein in Betrieb befindliches elektrisches System eingebettet oder eingebaut ist, wobei das Verfahren zum Messen des Zustands des Bauteils während des Betriebs des elektrischen Systems durchgeführt wird.

6. Messverfahren nach einem der Ansprüche 1 bis 5, bei dem die Messung der elektrischen Spannung V(ti) in Schritt b mit einer relativen Genauigkeit durchgeführt wird, die von der Art des Leistungselektronikbauteils abhängt, wobei diese relative Genauigkeit einen Wert von weniger als 5 % hat.

7. Messverfahren nach einem der Ansprüche 1 bis 6, bei dem die Verschlechterung die Verschlechterung der elektrischen Verbindungen der Bauteile betrifft.

8. Messverfahren nach einem der Ansprüche 1 bis 7, bei dem der dem Zeitpunkt ti in Schritt c) entsprechende Gesundheitszustand erhalten wird, ohne eine Reihe von Messungen durchzuführen, die darauf abzielen, eine Familie von Merkmalen bei verschiedenen Temperaturen zu zeichnen, um die Position des ZCP-Punktes abzuleiten, wobei der Schnittpunkt des Merkmalsstrahls, der einem gegebenen Gesundheitszustand entspricht, der ZCP-Punkt ist, der dem Gesundheitszustand entspricht, wobei die Spannung V, ZCP ein erstes Mal bestimmt wird, um die Spannung V,ZCPO zu erhalten, um Schritt a) des Verfahrens auszuführen.

9. Messverfahren nach einem der Ansprüche 1 bis 8, bei dem der Indikator D(ti) des Gesundheitszustands des elektronischen Bauteils zum Zeitpunkt ti durch einen Vergleich der Intensität zum Zeitpunkt ti I,ZCP(ti) mit der Intensität zum Anfangszeitpunkt I,ZCP(t0) bestimmt wird.

10. Messverfahren nach einem der Ansprüche 1 bis 9, bei dem der quantitative Indikator D(ti) des Gesundheitszustands des Bauteils zum Zeitpunkt ti durch Berechnung des Verhältnisses der Differenz der Intensität zum Zeitpunkt ti I,ZCP(ti) und der Intensität zum Anfangszeitpunkt I,ZCP(t0) und der Differenz der Intensität zu einem Endzeitpunkt I, ZCP(tfinal) und der Intensität zum Anfangszeitpunkt I,ZCP(t0) bestimmt, wobei die Intensität zum Endzeitpunkt I,ZCP(tfinal) der Wert ist, der erreicht wird, wenn der Verschlechterungsgrad des Bauteils dessen Austausch erfordert, und wobei die Intensität zum Anfangszeitpunkt I,ZCP(t0) der Intensität des Bauteils in einem gesunden Zustand entspricht.

11. Vorrichtung zur Messung des Gesundheitszustands zu einem oder mehreren Zeitpunkten ti mindestens eines Leistungshalbleiterbauelements durch Berechnung eines quantitativen Indikators D(ti) für die Verschlechterung des Leistungshalbleiterbauelements, um die Entwicklung der Alterung des Leistungshalbleiterbauelements zu bestimmen,

wobei die Messvorrichtung mindestens einen Eingangsanschluss und einen Ausgangsanschluss für elektrischen Strom der Stärke I umfasst, zwischen denen eine elektrische Spannung V aufgebaut wird, wobei das Leistungselektronikbauteil einen Null-Temperaturkoeffizienten-Punkt ZCP aufweist, der durch eine elektrische Stromstärke I,ZCP und eine Spannung V,ZCP definiert ist, wobei ZCP temperaturunabhängig ist,
wobei die Vorrichtung einen elektrischen Stromsensor, einen elektrischen Spannungssensor und einen Prozessor umfasst, der Informationen mit den Sensoren austauscht, und für die Durchführung der folgenden Schritte konfiguriert ist:

a. ein erster Schritt des Bestimmens, zu einem Anfangszeitpunkt t0, eines ersten Stroms I(t0) = I,ZCP0, wenn die Spannung V gleich einer Spannung V(t0)=V,ZCP0 ist, wobei sich das Leistungselektronikbauteil in einem "Anfangszeitpunkt"-Zustand befindet;
b. einen Schritt des Messens eines Wertes des Stroms I zu jedem nachfolgenden Zeitpunkt ti, wenn die Spannung V zum Zeitpunkt ti gleich der Spannung V,ZCPO ist, wobei sich die Leistungselektronikkomponente in einem Zustand "Augenblick ti" befindet;
c. einen Schritt der Berechnung eines quantitativen Indikators D(ti) der Alterung des Leistungselektronikbauteils zu jedem nachfolgenden Zeitpunkt ti durch den Prozessor, dessen Wert eine Funktion der Änderung des Wertes der Intensität I zwischen dem Zustand "Anfangszeitpunkt" und dem "Zeitpunkt ti" ist, wobei die Alterung unabhängig von der Spannung V,ZCP ist, aber von der Intensität I,ZCP abhängt, die mit der Alterung abnimmt.

12. Messvorrichtung nach Anspruch 11, **dadurch gekennzeichnet, dass** das mindestens eine Leistungshalbleiterbauelement bipolar oder gemischt ist.

13. Leistungselektronikmodul mit einer Messvorrichtung nach einem der Ansprüche 11 bis 12 für mindestens zwei elektronische Bauelemente in Parallel- und/oder Reihenschaltung.

14. System mit einem oder mehreren Leistungselektronikmodulen gemäß Anspruch 13, wobei die Vorrichtung zum Messen des Gesundheitszustands mindestens eines Leistungselektronikbauteils, das in jedem Modul integriert ist, einen quantitativen Indikator für die Verschlechterung bereitstellt.

15. System mit einem oder mehreren Leistungselektronikmodulen gemäß Anspruch 14, wobei das System ein elektrisches Energiemanagement- und/oder elektrisches Energieumwandlungssystem für erneuerbare Energien oder ein elektrisches Traktionsverkehrssystem oder ein stationäres System ist.

16. Computerprogramm, das Programmcodeanweisungen zum Ausführen der Schritte des Verfahrens zum Messen des Gesundheitszustands eines leistungselektronischen Halbleiterbauelements gemäß einem der Ansprüche 1 bis 10 umfasst, wenn das Programm durch die Vorrichtung gemäß Anspruch 11 ausgeführt wird.

17. Computerprogramm gemäß Anspruch 16, bei dem das Verfahren zum Messen des Gesundheitszustands auf das System angewendet wird, das ein oder mehrere Leistungselektronikmodule gemäß einem der Ansprüche 14 bis 15 enthält, wobei, wenn das Messverfahren einen quantitativen Indikator für eine Verschlechterung zurückgibt, der größer als ein vorbestimmter Schwellenwert ist, das Berechnungsprogramm das Messverfahren auf jede Leistungshalbleiter-Elektronikkomponente des Systems anwendet, das ein oder mehrere Leistungselektronikmodule enthält.

**Claims**

1. Method of measuring the state of health at several instants ti of at least one solid-state power electronic component by calculating a quantitative indicator D(ti) of the degradation of the power electronic component, in order to determine the evolution of the ageing of said power electronic component,

the power electronic component comprising at least one input terminal and one output terminal for an electric current of intensity I, between which a voltage V is established,

the power electronic component having a zero temperature coefficient point ZCP defined by an electric current intensity I,ZCP and a voltage V,ZCP, ZCP being independent of temperature,

the method using an electric current sensor, an electric voltage sensor and a processor exchanging information with said sensors,

the method comprising:

a- a first step of determining, at an initial time t0, a first value of the current I(t0)=I,ZCP0 when the electric voltage V is equal to a voltage V(t0)=V, ZCPO, the power electronic component then being in an 'initial instant' state; b- a step of measuring a value of the current I at each subsequent instant ti, when the voltage V at instant ti of the power electronic component is equal to the voltage V,ZCPO, the power electronic component then being in an 'instant ti' state;

c- a step in which the processor calculates a quantitative indicator D(ti) of the ageing of the power electronic component at each subsequent instant ti, the value of which is a function of the variation in the value of the current I between the 'initial instant' state and the

'instant ti', the ageing being independent of the voltage V,ZCP but dependent on the intensity I,ZCP which decreases with ageing.

2. Measuring method according to claim 1, comprising a measurement of the intensity I,ZCP(ti) when the DC voltage is at the value V, ZCPO, where the electric current intensity I(ti) in the instant state ti corresponds to the intensity I,ZCP(ti) at the point of zero temperature coefficient of the electronic component, the measurement being made without it being necessary to make any additional measurement, in particular by means of a temperature sensor.

3. Measuring method according to one of claims 1 and 2, in which no temperature sensor is used and no temperature estimation is necessary for steps a, b and c, the quantitative indicator D(ti) of the degradation of the electronic component being independent of the temperature.

4. Measuring method according to one of claims 1 to 3, in which the measuring method comprises, before step a: i- a stage comprising at least two series of measurements of the electric current intensity I by the electric current intensity sensor and of the electric voltage V by the electric voltage sensor, the series of measurements (I,V) being taken at different temperatures; ii - a stage of calculation by the processor of the electric voltage value V,ZCPO and of the electric current value I, ZCP0 at the zero temperature coefficient point ZCP, based on the measurements from step i, the zero temperature coefficient point ZCP being the point of intersection of the two series of measurements (I, V) from step i, the current I(t0) and the voltage V(t0) in the 'initial instant' state being equal to I,ZCP0 and V,ZCPO respectively.

5. Measuring method according to any one of claims 1 to 4, in which the at least one power semiconductor electronic component is embedded or installed in an operating electrical system, the method of measuring the health of the component being carried out during operation of the electrical system.

6. Measuring method according to any one of claims 1 to 5, in which the measurement of the electrical voltage V(ti) is carried out in step b with a relative accuracy which depends on the type of the power electronic component, this relative accuracy having a value of less than 5%.

7. Measuring method according to any one of claims 1 to 6, in which the degradation concerns the degradation of the electrical interconnections of the components.

8. Measuring method according to any one of claims 1 to 7, in which the state of health corresponding to the instant ti in step c) is obtained without carrying out a series of measurements aimed at plotting a family of characteristics at different temperatures so as to deduce the position of the ZCP point, where the point of intersection of the beam of characteristics corresponding to a given state of health is the ZCP point corresponding to the said state of health, the voltage V, ZCP being determined a first time to obtain the voltage V,ZCPO so as to implement step a) of said method.

9. Measuring method according to any one of claims 1 to 8, in which the indicator D(ti) of the state of health of the electronic component at time ti is determined by a comparison of the intensity at time ti I,ZCP(ti) with the intensity at the initial time I,ZCP(t0).

10. Measuring method according to any one of claims 1 to 9, in which the quantitative indicator D(ti) of the state of health of the component at time ti is determined by calculating the ratio of the difference of the intensity at time ti I,ZCP(ti) and the intensity at the initial time I,ZCP(t0) and the difference of the intensity at a final time I,ZCP(tfinal) and the intensity at the initial time I,ZCP(t0) where the intensity at the final time I,ZCP(tfinal) is the value reached when the level of degradation of the component requires its replacement and where the intensity at the initial time I,ZCP(t0) corresponds to the intensity of the component in a healthy state.

11. Device for measuring the state of health at one or more instants ti of at least one semiconductor power electronic component by calculating a quantitative indicator D(ti) of the degradation of the power electronic component, to determine the evolution of the ageing of said power electronic component,

the measuring device comprising at least one input terminal and one output terminal for electric current of intensity I, between which an electric voltage V is established, the power electronic component having a zero temperature coefficient point ZCP defined by an electric current intensity I,ZCP and a voltage V,ZCP, ZCP being independent of temperature,
the device comprising an electric current sensor, an electric voltage sensor and a processor exchanging information with said sensors, configured for the implementation of the following steps:

a. a first step of determining, at an initial time t0, a first current I(t0) = I,ZCP0, when the voltage V is equal to a voltage V(t0)=V,ZCP0, the power electronic component being in an 'initial time' state ;
b. a step of measuring a value of the current I at each subsequent instant ti, when the voltage V at the instant ti is equal to the voltage V,ZCPO, the power electronic component being in an 'instant ti' state;
c. a step of calculation by the processor of a quantitative indicator D(ti) of the ageing of the power electronic component at each subsequent instant ti and whose value is a function of the variation of the value of the intensity I between the 'initial instant' state and the 'instant ti', the ageing being independent of the voltage V,ZCP but dependent on the intensity I,ZCP which decreases with ageing.

12. Measuring device according to claim 11, **characterized in that** the at least one semiconductor power electronic component is bipolar or mixed.

13. Power electronics module incorporating a measuring device according to one of claims 11 to 12 for at least two electronic components in parallel and/or series.

14. System incorporating one or more power electronics modules according to claim 13, the device for measuring the state of health of at least one power electronics component power electronics component integrated in each module providing a quantitative indicator of degradation.

15. System incorporating one or more power electronics modules according to claim 14, the system being an electrical energy management and/or electrical energy conversion system for renewable energy or an electric traction transport system or a stationary system.

16. Computer program comprising program code instructions for carrying out the steps of the method of measuring the state of health of a power electronic semiconductor component according to any one of claims 1 to 10 when said program is executed by the device of claim 11.

17. Computer program according to claim 16, in which the method of measuring the health status is applied to the system incorporating one or more power electronic modules according to any one of claims 14 to 15, wherein if the measuring method returns a quantitative indicator of degradation greater than a predetermined threshold value, the calculation program applies the measuring method to each power semiconductor electronic component of the system incorporating one or more power electronic modules.

Fig. 1

Etat de l'art

Fig. 2

Etat de l'art

Fig. 3

Fig. 4

Fig. 5a

Etat de l'art

Fig. 5b

Fig. 5c

Fig. 6

Fig. 7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2564163 A2

**Littérature non-brevet citée dans la description**

- **H. OH** ; **B. HAN** ; **P. MCCLUSKEY** ; **C. HAN** ; **B. D. YOUN**. Physics-of-Failure, Condition Monitoring, and Prognostics of Insulated Gate Bipolar Transistor Modules: A Review. *IEEE Transactions on Power Electronics*, May 2015, vol. 30 (5), 2413-2426
- **A. ARYA** ; **A. CHANEKAR** ; **P. DESHMUKH** ; **A. VERMA** ; **S. ANAN**. Accurate Online Junction Temperature Estimation of IGBT Using Inflection Point Based Updated I-V Characteristics. *IEEE Transactions on Power Electronics*, September 2021, vol. 36 (9), 9826-9836

- **N. DEGRENNE** ; **S. MOLLOV**. On-line Health Monitoring of Wire-Bonded IGBT Power Modules using On-State Voltage at Zero-Temperature-Coefficient. *PCIM Europe 2018 ; International Exhibition and Conference for Power Electronics, Intelligent Motion, Renewable Energy and Energy management*, 2018, 1-7
- **A. ARYA** ; **A. CHANEKAR** ; **P. DESHMUKH** ; **A. VERMA** ; **S. ANAND**. Accurate Online Junction Temperature Estimation of IGBT Using Inflection Point Based Updated I-V Characteristics. *IEEE Transactions on Power Electronics*, September 2021, vol. 36 (9), 9826-9836